# EUROPEAN PATENT APPLICATION

(11) **EP 4 671 665 A1**
(43) Date of publication of application: **31.12.2025**
(21) Application number: 25153803.9
(22) Date of filing: 24.01.2025
(51) Int. Cl.: F28F 3/12, F28D 15/04, F28D 15/02, F28F 3/02, H01L 23/427, F28F 3/04

(54) **VAPOR CHAMBER DEVICE**

(30) Priority: 24.06.2024 TW 113123338
(71) Applicant: National Tsing Hua University, Hsinchu City 30013 (TW)
(72) Inventor: WONG, Shwin-Chung, 30013 Hsinchu City (TW)
(74) Representative: Becker, Eberhard

(57) **Abstract**

A vapor chamber device (100, 100a to 100d) includes a first shell (110, 110a), a second shell (120, 120a, 120b), and a second capillary structure (130). The first shell (110, 110a) includes a first capillary structure (114) on an inner surface (112) including a first region (112a) and a second region (112b) of a first plate (111) and including first trenches (116) formed between first ridges (115) in the first region (112a) and second trenches (118) formed between second ridges (117) in the second region (112b). A width (W2) of each second trench (118) is less than a width (W1) of each first trench (116). The second shell (120, 120a, 120b) is on the first shell (110, 110a) and includes supporting posts (122, 123, 125) protruding from a second plate (121). The second capillary structure (130) is between the first capillary structure (114) and the supporting posts (122, 123, 125).

## Description

### BACKGROUND

### Technical Field

The disclosure relates to a vapor chamber device, and in particular, relates to a vapor chamber device with improved heat dissipation efficiency.

### Description of Related Art

Vapor chambers are common heat dissipation devices. A vapor chamber mainly includes a flat sealed shell, a capillary structure formed in the flat sealed shell, and a working fluid filled in the flat sealed shell. The flat sealed shell contacts a plurality of heat sources, such as a central processing unit (CPU) or a graphics processing unit (GPU), and dissipates heat from the heat source by the vapor-liquid phase change of the working fluid in the vapor chamber. Therefore, how to improve the heat dissipation of the vapor chamber is the research direction of this field.

### SUMMARY

The disclosure provides a vapor chamber device exhibiting favorable heat dissipation performance.

The disclosure provides a vapor chamber device including a first shell, a second shell, and a second capillary structure. The first shell includes a first plate, a first capillary structure located on an inner surface of the first plate, and a first side wall protruding from the inner surface and surrounding the first capillary structure. Herein, the first capillary structure acts as a liquid channel. The inner surface includes a first region and a second region. The first capillary structure includes a plurality of first trenches formed between a plurality of first ridges and a plurality of second trenches formed between a plurality of second ridges. The first ridges and the first trenches are located in the first region, and the second ridges and the second trenches are located in the second region. A width of each of the second trenches is less than a width of each of the first trenches. The second shell is stacked on the first shell and includes a second plate, a plurality of supporting posts protruding from the second plate, and a second side wall protruding from the second plate and surrounding the supporting posts. A plurality of steam channels are formed between the supporting posts. The supporting posts face the first capillary structure, and the first side wall is bonded to the second side wall. The second capillary structure is disposed between the first capillary structure and the supporting posts of the second shell.

In an embodiment of the disclosure, the vapor chamber device further includes a heat source disposed adjacent to an outer surface of the first plate and thermally coupled to the first plate. The second trenches are disposed corresponding to the heat source, and the first trenches are disposed corresponding to locations outside the heat source.

In an embodiment of the disclosure, a ratio of the width of each of the second trenches to the width of each of the first trenches is between 0.3 and 0.9.

In an embodiment of the disclosure, the vapor chamber device further includes a third capillary structure disposed in at least one strong heat dissipation portion in the second region. The third capillary structure is not provided in a remaining portion of the second region outside the at least one strong heat dissipation portion.

In an embodiment of the disclosure, the second region is filled with the second trenches.

In an embodiment of the disclosure, the second trenches are only located in a portion of the second region, the at least one strong heat dissipation portion is located in a portion of the second region where the second trenches are not located, and the at least one strong heat dissipation portion is provided with a plurality of protruding posts abutting against the second capillary structure.

In an embodiment of the disclosure, a ratio of an area of the at least one strong heat dissipation portion where the third capillary structure is disposed to an area occupied by the second region is less than 0.5.

In an embodiment of the disclosure, a ratio of an area of the at least one strong heat dissipation portion where the third capillary structure is disposed to an area occupied by the second region is less than 0.25.

In an embodiment of the disclosure, the vapor chamber device further includes a heat source disposed adjacent to an outer surface of the first plate and thermally coupled to the first plate. The heat source includes at least one hot spot and a relatively non-hot spot region outside the at least one hot spot. A position of the at least one strong heat dissipation portion where the third capillary structure is disposed corresponds to a position of the at least one hot spot.

In an embodiment of the disclosure, the position of the at least one strong heat dissipation portion corresponds to a center of the heat source. The remaining portion of the second trenches surrounds the strong heat dissipation portion.

In an embodiment of the disclosure, the first shell further comprises a plurality of top bonding posts, the top bonding posts are disposed on the inner surface of the first plate and directly connected to the second plate.

To sum up, in the vapor chamber device provided by the disclosure, the inner surface of the first shell includes the first region and the second region. The first capillary structure located on the inner surface includes the first ridges and the first trenches located in the first region and the second ridges and the second trenches located in the second region. The width of each of the second trenches is less than the width of each of the first trenches. Through such a design, the capillary force of these second trenches is enhanced, and the heat dissipation efficiency is thus effectively improved.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1A is a schematic view of an appearance of a vapor chamber device according to an embodiment of the disclosure.
FIG. 1B is a schematic cross-sectional view of the vapor chamber device of FIG. 1A taken along a line segment A-A.
FIG. 2A is a cross-sectional schematic view of a vapor chamber device according to another embodiment of the disclosure.
FIG. 2B is a graph showing experimental results of the *R* value (thermal resistance)-*Q* value (heat) of different vapor chamber devices.
FIG. 3A is a cross-sectional schematic view of a vapor chamber device according to another embodiment of the disclosure.
FIG. 3B is a schematic top view of a second region of a first shell of FIG. 3A.
FIG. 4A is a schematic view of an inner surface of a second shell of the vapor chamber device of FIG. 1A.
FIG. 4B and FIG. 4C are schematic views of an inner surface of a second shell according to other embodiments of the disclosure.
FIG. 4D is a schematic view of an inner surface of a first shell according to other embodiments of the disclosure.
FIG. 5A and FIG. 5B are cross-sectional schematic views of vapor chamber devices according to other embodiments of the disclosure.

### DESCRIPTION OF THE EMBODIMENTS

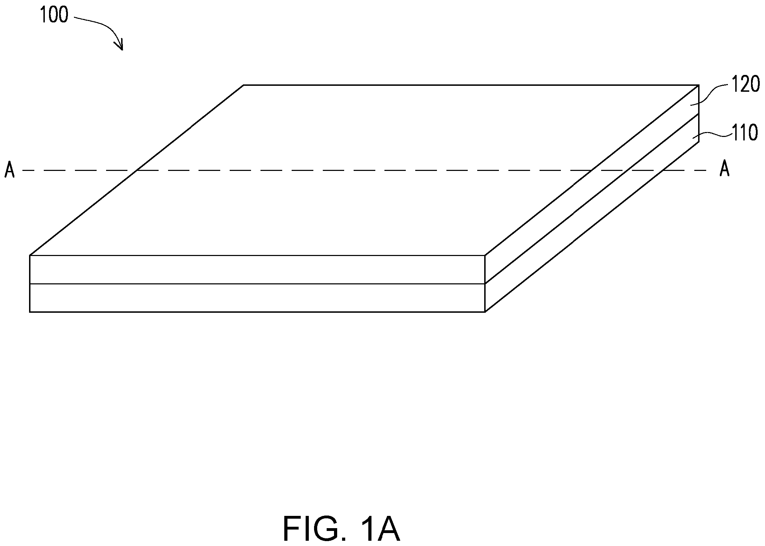

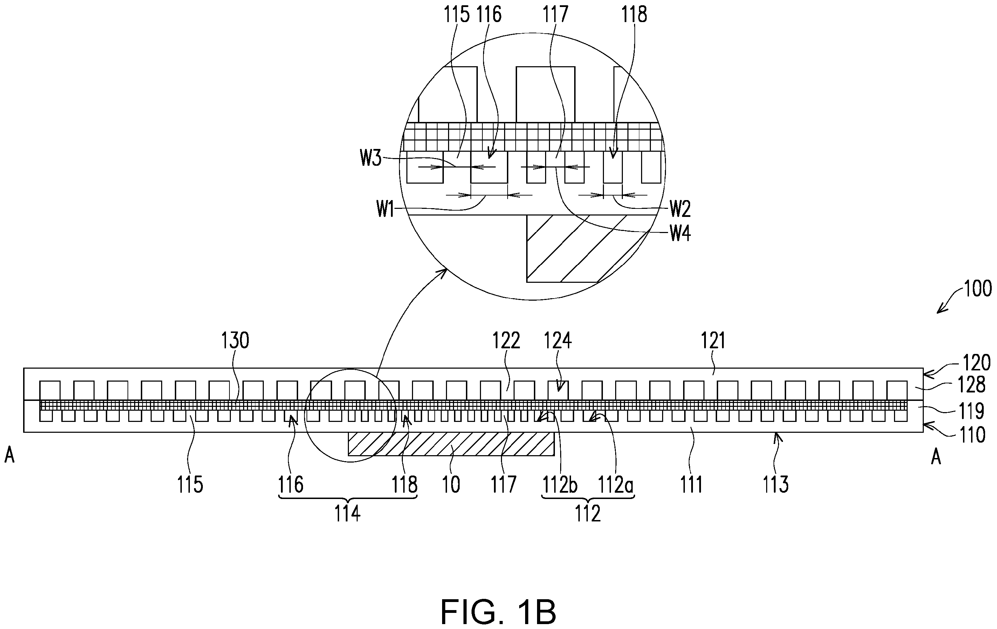

FIG. 1A is a schematic view of an appearance of a vapor chamber device according to an embodiment of the disclosure. FIG. 1B is a schematic cross-sectional view of the vapor chamber device of FIG. 1A taken along a line segment A-A.

With reference to FIG. 1A and FIG. 1B, an appearance of a vapor chamber device 100 of this embodiment is, for example, a rectangular plate, but the appearance of the vapor chamber device 100 may be any shape and is not limited to the figure. The vapor chamber device 100 is adapted to be thermally coupled to a heat source 10 (FIG. 1B). The heat source 10 is, for example, a central processing unit of a motherboard, but the heat source 10 may also be other chips, and the type and number of the heat source 10 are not limited thereto.

As shown in FIG. 1B, the vapor chamber device 100 includes a first shell 110, a second shell 120, and a second capillary structure 130. The first shell 110 includes a first plate 111, a first capillary structure 114 located on an inner surface 112 of the first plate 111, and a first side wall 119 protruding from the inner surface 112 and surrounding the first capillary structure 114. The heat source 10 is disposed adjacent to an outer surface 113 of the first plate 111 and is thermally coupled to the first plate 111.

The first capillary structure 114 acts as a liquid channel. The first capillary structure 114 includes a plurality of first trenches 116 formed between a plurality of first ridges 115 and a plurality of second trenches 118 formed between a plurality of second ridges 117.

The inner surface 112 of the first plate 111 includes a first region 112a and a second region 112b. The first ridges 115 and the first trenches 116 are located in the first region 112a, and the second ridges 117 and the second trenches 118 are located in the second region 112b. In this embodiment, the second trenches 118 are disposed corresponding to the heat source 10, and the first trenches 116 are disposed corresponding to locations outside the heat source 10. In addition, in this embodiment, the second region 112b is filled with the second trenches 118.

In this embodiment, the first plate 111, the first ridges 115, and the second ridges 117 are integrally formed, and such a design can exhibit a simpler structure. Since the first plate 111, the first ridges 115, and the second ridges 117 do not have thermal contact resistance, an improved heat transfer effect is provided.

As shown in the partial enlarged view of FIG. 1B, a width W2 of each of the second trenches 118 is less than a width W1 of each of the first trenches 116. Such a design enables the first capillary structure 114 of the first shell 110 to be provided with the narrower and denser second trenches 118 in the second region 112b corresponding to the heat source 10, and having improved capillary force at the location corresponding to the heat source 10 may provide an improved heat dissipation effect.

A ratio of the width W2 of each of the second trenches 118 to the width W1 of each of the first trenches 116 is between 0.3 and 0.9. The width W2 of each of the second trenches 118 may be a minimum width within the process limitation, but is not limited thereto.

In this embodiment, the width W1 of each of the first trenches 116 is, for example, between 100 micrometers and 400 micrometers, and a depth of each of the first trenches 116 and the second trenches 118 is, for example, between 50 micrometers and 200 micrometers. However, the width W1 and depth of each of the first trenches 116 are not limited thereto.

The second shell 120 is stacked on the first shell 110 and includes a second plate 121, a plurality of supporting posts 122 protruding from the second plate 121, and a second side wall 128 protruding from the second plate 121 and surrounding the supporting posts 122. A plurality of steam channels 124 are formed between the supporting posts 122.

The supporting posts 122 may include a plurality of rectangular posts, a plurality of conical posts, a plurality of trapezoidal posts, a plurality of circular posts, or a plurality of irregularly-shaped posts. Therefore, the cross-sectional shape of the supporting posts 122 may be a triangle, an arc, or other shapes. Similarly, the cross-sectional shape of the steam channel 124 may be a triangle, an arc, or other shapes.

The supporting posts 122 face the first capillary structure 114, and the first side wall 119 is bonded to the second side wall 128. In this embodiment, the first shell 110 and the second shell 120 are, for example, two metal shells, and the first side wall 119 is bonded to the second side wall 128 to provide favorable structural strength. The first side wall 119 and the second side wall 128 are bonded by diffusion bonding or welding, for example, but not limited thereto.

In this embodiment, the supporting posts 122 are at the same height and level with the second side wall 128, but the relationship between the supporting posts 122 and the second side wall 128 is not limited thereto. Further, in this embodiment, the first capillary structure 114 is slightly lower than the first side wall 119, and the second capillary structure 130 is approximately flush with the first side wall 119 when being disposed on the first capillary structure 114. In this way, when the first side wall 119 is bonded to the second side wall 128, the supporting posts 122 can press against the second capillary structure 130. Certainly, in other embodiments, the above height relationship is not limited thereto.

It should be mentioned that in this embodiment, an appropriate amount of working fluid, such as water, is filled into an inner space surrounded by the first shell 110 and the second shell 120, but the type of the working fluid is not limited thereto. The working fluid, for example, flows in the first capillary structure 114 of the first shell 110 in the form of liquid. The working fluid absorbs heat in the region close to the heat source 10 and evaporates into steam. The steam channel 124 of the second shell 120 may be evacuated to make the pressure herein less than 1 atmosphere (e.g., close to vacuum), so that when the phase of the working fluid changes in the subsequent process, the air pressure herein may be prevented from being excessively high to cause the first shell 110 and the second shell 120 to separate.

Therefore, in this embodiment, the supporting posts 122 abut against with the second capillary structure 130 to support the second plate 121, so that the first shell 110, the second shell 120 and the steam channel 124 are effectively prevented from collapsing during vacuuming. Further, when the working fluid condenses from vapor to liquid, the working fluid may also flow down along the side walls of the supporting posts 122. That is, the supporting posts 122 may also act as a structure for guiding the working fluid (liquid) to flow downward.

In addition, the second capillary structure 130 is disposed between the first capillary structure 114 and the supporting posts 122 of the second shell 120. The capillary force of a simple open trench is insufficient and is not suitable for a non-horizontally placed vapor chamber device 100. Covering with a layer of mesh second capillary structure 130 allows the advantage of low flow resistance of the trenches to be maintained, and the capillary force is significantly improved, making the vapor chamber device 100 suitable for non-horizontal placement.

In this embodiment, the second capillary structure 130 is a mesh structure woven by a plurality of wires, such as a copper mesh. Certainly, in other embodiments, the second capillary structure 130 may also be a non-woven mesh or a porous foamed metal capillary structure, and the form of the second capillary structure 130 is not limited thereto.

It is worth mentioning that as can be seen in FIG. 1B, since the second capillary structure 130 is disposed on the first capillary structure 114, an upper portion of the first capillary structure 114 is covered by the second capillary structure 130, and a capillary structure is formed in an extending direction (the direction of exiting or entering the drawing) of the first trenches 116 and the second trenches 118. This structure enables the working fluid in the first trenches 116 and the second trenches 118 to resist gravity, so that the vapor chamber device 100 may complete a thermal cycle well in a non-horizontal state.

The outer surface 113 of the first shell 110 of the vapor chamber device 100 contacts the heat source 10, and the heat generated by the heat source 10 is transferred to the first shell 110. The region of the vapor chamber device 100 corresponding to the heat source 10 is called an evaporation region. In the evaporation region, the liquid in the second trenches 118 absorbs heat and evaporates into steam. The working fluid (vapor) flows upward to the steam channel 124 of the second shell 120 and diffuses in an internal steam chamber of the second shell 120, and then condenses into liquid in a condensation region (e.g., the outer surface 113 of the second shell 120 or a selected region of the outer surface 113 of the first shell 110 that is not in contact with the heat source 10) of the vapor chamber device, discharges heat out of the vapor chamber device 100, and condenses into liquid. The condensed working fluid (liquid) flows downward to the first trenches 116 and the second trenches 118 of the first shell 110, completing the cycle.

In this embodiment, in the vapor chamber device 100, by providing the second trenches 118 with smaller width and higher density at the location corresponding to the heat source 10, a greater capillary force may be provided at the location corresponding to the heat source 10, so that the heat dissipation efficiency is effectively improved. In addition, in the vapor chamber device 100, the first trenches 116 with larger width and smaller spacing are disposed outside the heat source 10. The flow resistance is thereby effectively reduced, and the circulation force is improved.

It is worth mentioning that if the heat source 10 has a non-uniform heat output per unit area or heat flux, there will be hot spots 12 with higher heat flux where drying most often occurs. The following embodiments provide improvements on this aspect.

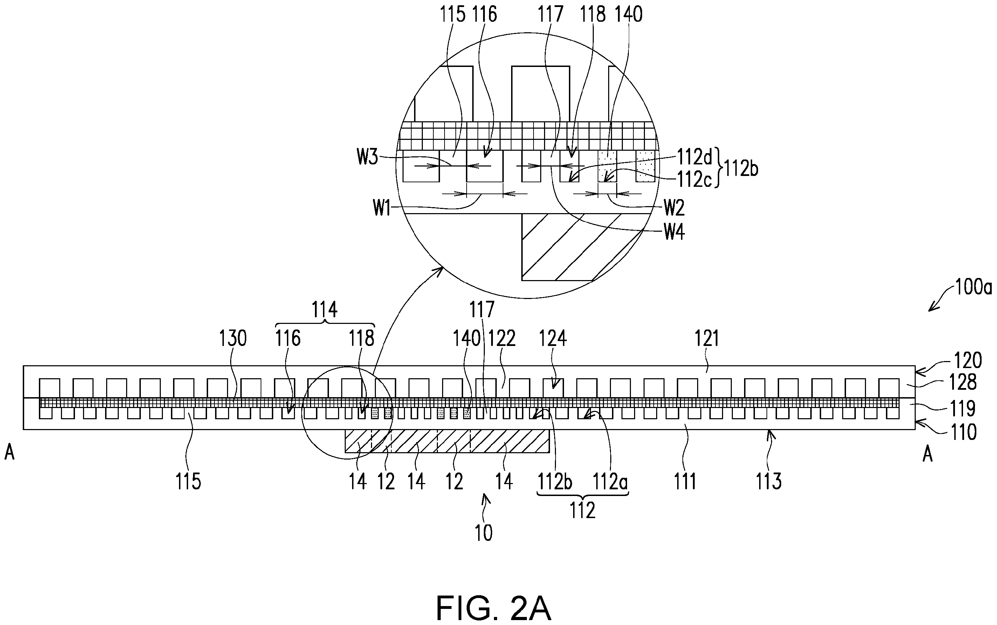

FIG. 2A is a cross-sectional schematic view of a vapor chamber device according to another embodiment of the disclosure. With reference to FIG. 2A, in this embodiment, the heat source 10 includes at least one hot spot 12 and a relatively non-hot spot region 14 outside the at least one hot spot 12.

A vapor chamber device 100a further includes a third capillary structure 140. The third capillary structure 140 is disposed in at least one strong heat dissipation portion 112c in the second region 112b. A position of the at least one strong heat dissipation portion 112c where the third capillary structure 140 is disposed corresponds to a position of the at least one hot spot 12. The third capillary structure 140 is not provided in a remaining portion 112d of the second region 112b outside the at least one strong heat dissipation portion 112c.

In this embodiment, the number of the at least one hot spot 12 is, for example, two, and the second region 112b includes two strong heat dissipation portions 112c. The third capillary structure 140 is only disposed in the two strong heat dissipation portions 112c corresponding to the two hot spots 12 in the second region 112b.

In this embodiment, the third capillary structure 140 is exemplified by a sintered capillary structure. For instance, metal powder is sintered in regions of the second trenches 118 corresponding to the strong heat dissipation portions 112c. In an embodiment that is not shown, the third capillary structure 140 may also include metal powder, and the metal powder is filled into the regions of the second trenches 118 of the first capillary structure 114 corresponding to the strong heat dissipation portions 112c. Certainly, in other embodiments, the form of the third capillary structure 140 is not limited thereto.

In this embodiment, the third capillary structure 140 is filled in the regions of the second trenches 118 of the first capillary structure 114 in the evaporation region corresponding to the strong heat dissipation portions 112c. Since the sintered material may provide the liquid with a favorable capillary environment, the working fluid may be easily absorbed into the evaporation region. In this way, the situation that the liquid in the evaporation region is not replenished in time after being vaporized is prevented from occurring, and favorable anti-drying ability is provided. Besides, the third capillary structure 140 is not disposed in regions of the first trenches 116 and the second trenches 118 of the first capillary structure 114 corresponding to the remaining portion 112d, so the low flow resistance is maintained. As such, the vapor chamber device 100a may be able to provide increased maximum heat dissipation capacity through the above design and may be applied to thin devices.

In other embodiments, if the heat source 10 is a graphics processing unit (GPU) chip, for example, and there is no specific hot spot 12, the positions of the strong heat dissipation portions 112c of the third capillary structure 140 correspond to a center of the heat source 10. The remaining portion 112d of the second trenches 118 surrounds the strong heat dissipation portions 112c. The position where the third capillary structure 140 is disposed is not limited to the above.

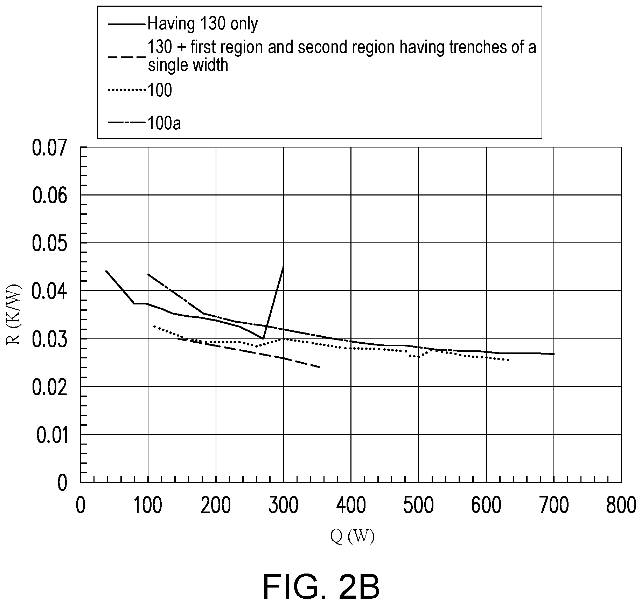

FIG. 2B is a graph showing experimental results of the R value (thermal resistance)-Q value (heat) of different vapor chamber devices. With reference to FIG. 2B, the vapor chamber devices all have an area of 140×80 mm², the heated evaporation regions all have an area (i.e., the area of the heat source 10) of 30×30 mm², thicknesses of the trenches do not exceed 0.2mm, and thicknesses of these vapor chamber devices are between 0.7mm and 1.0mm.

The experimental results show that a *Q*ₘₐₓ of the vapor chamber device with only the second capillary structure 130 (i.e., without the first capillary structure 114 and the third capillary structure 140) is 259W. The *Q*ₘₐₓ of the vapor chamber device using the second capillary structure 130 and having the first region 112a and the second region 112b of the first shell 110 provided with trenches of a single width (the first shell 110 only has first trenches 116 that are uniformly distributed) is 350W. The *Q*ₘₐₓ of the vapor chamber device 100 of FIG. 1B is 632 W, and the *Q*ₘₐₓ of the vapor chamber device 100a similar to FIG. 2A (10×10 mm² in the center of the evaporation region is filled with copper powder) is increased to 700 W.

As shown in FIG. 2B, the performance of the vapor chamber device 100 in FIG. 1B is better than the performance of the vapor chamber device using the second capillary structure 130 and the first capillary structure 114 having trenches of a single width, and the performance of the vapor chamber device 100a of FIG. 2A is better than that of the vapor chamber device 100 of FIG. 1B. The heat dissipation performance of the vapor chamber devices 100 and 100a provided by the disclosure is strong and may be applied to the air cooling heat dissipation module of high-power chips (e.g., AI chips, GPUs, server CPUs, etc.).

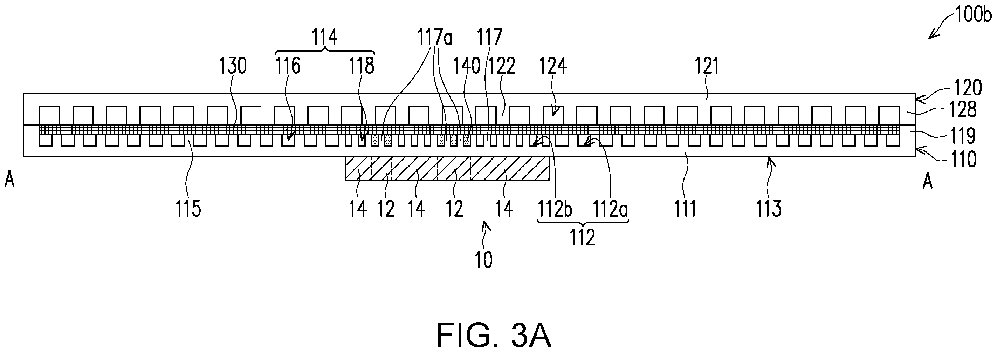

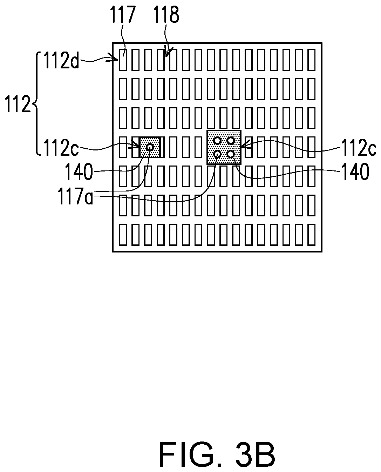

FIG. 3A is a cross-sectional schematic view of a vapor chamber device according to another embodiment of the disclosure. FIG. 3B is a schematic top view of a second region of a first shell of FIG. 3A. With reference to FIG. 3A and FIG. 3B, the main difference between a vapor chamber device 100b of FIG. 3A and FIG. 3B and the vapor chamber device 100 of FIG. 1B is that in this embodiment, the second trenches 118 are only located in a portion of the second region 112b, the at least one strong heat dissipation portion 112c is located in a portion of the second region 112b where the second trenches 118 are not located, and the at least one strong heat dissipation portion 112c is provided with a plurality of protruding posts 117a abutting against the second capillary structure 130. The protruding posts 117a are used to provide supporting force.

As shown in FIG. 3B, a ratio of an area of the at least one strong heat dissipation portion 112c where the third capillary structure 140 is disposed to an area occupied by the second region 112b is less than 0.5. To be more specific, the ratio of the area of theat least one strong heat dissipation portion 112c where the third capillary structure 140 is disposed to the area ofthe second region 112b is less than 0.25, or even less than 0.1. In other words, the third capillary structure 140 only needs to be set at the hot spots 12 and does not need to be distributed over a large area to achieve a good effect.

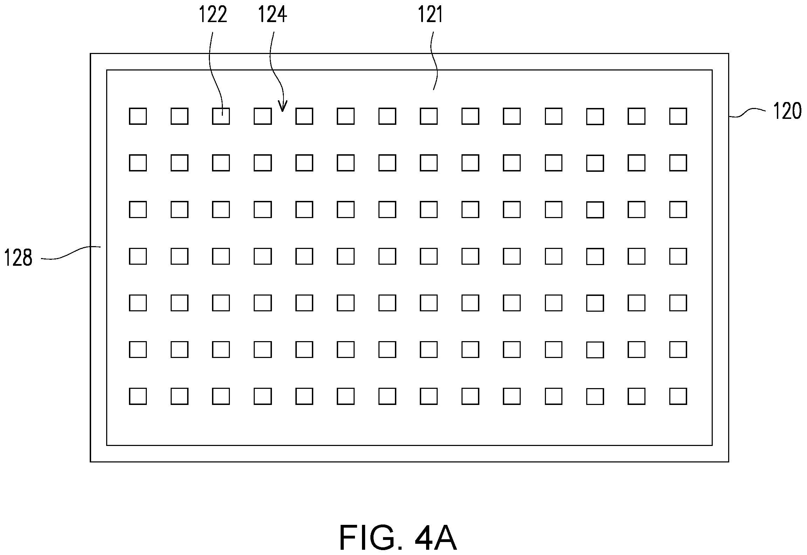

FIG. 4A is a schematic view of an inner surface of a second shell of the vapor chamber device of FIG. 1A. In this embodiment, the supporting posts 122 have consistent shapes and are evenly distributed on the inner surface of the second plate. The supporting posts 122 are, for example, square posts, but in other embodiments, the supporting posts 122 may also be rectangular posts, circular posts, elliptical posts, polygonal posts, conical posts, irregular posts, or/and a combination of the foregoing. The shapes and distribution forms of the supporting posts 122 are not limited thereto. The supporting posts 122 are integrally formed with the second plate 121, but may also be bonded by welding, gluing, or other methods.

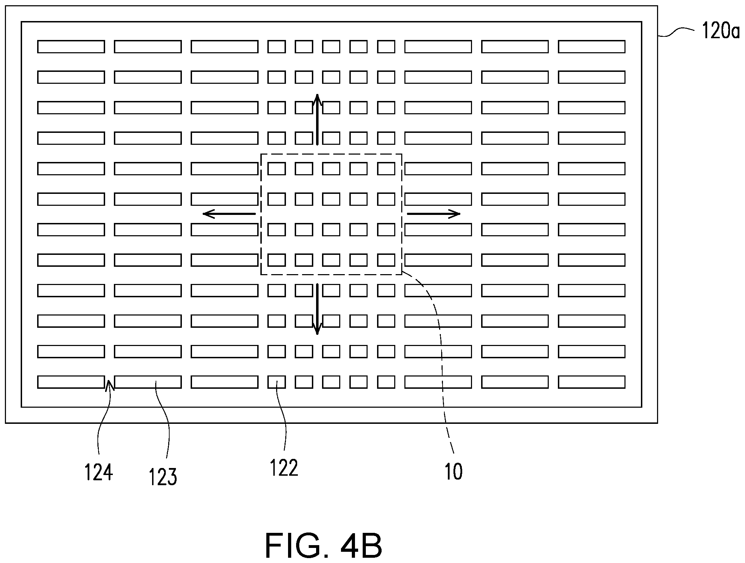

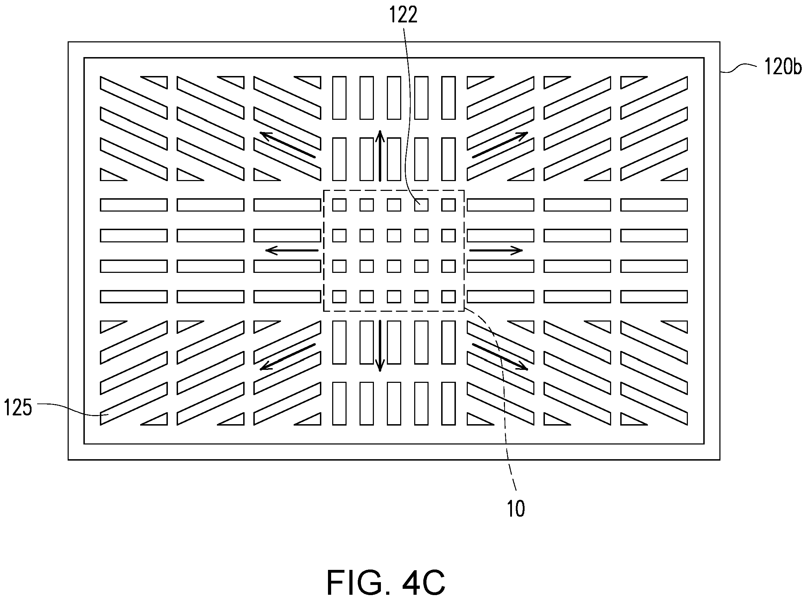

FIG. 4B and FIG. 4C are schematic views of an inner surface of a second shell according to other embodiments of the disclosure. With reference to FIG. 4B first, the main difference between a second shell 120a in FIG. 4B and the second shell 120 in FIG. 4A is that in this embodiment, the second shell 120a further includes supporting posts 123, and the shapes of the supporting posts 122 are different from that of the supporting posts 123. In this embodiment, the second shell is provided with high-density supporting posts 122 at the position corresponding to the heat source to provide favorable structural strength. The supporting posts 123 are disposed on both sides of the supporting posts 122 and extend to guide a flow direction of the working fluid (vapor).

With reference to FIG. 4C, the main difference between a second shell 120b in FIG. 4C and the second shell 120a in FIG. 4B is that in this embodiment, the supporting posts 122 are disposed at locations corresponding to the heat source 10, and supporting posts 125 are radially arranged with the supporting posts 122 as the center. Such a design can also well guide the flow direction of the working fluid (vapor).

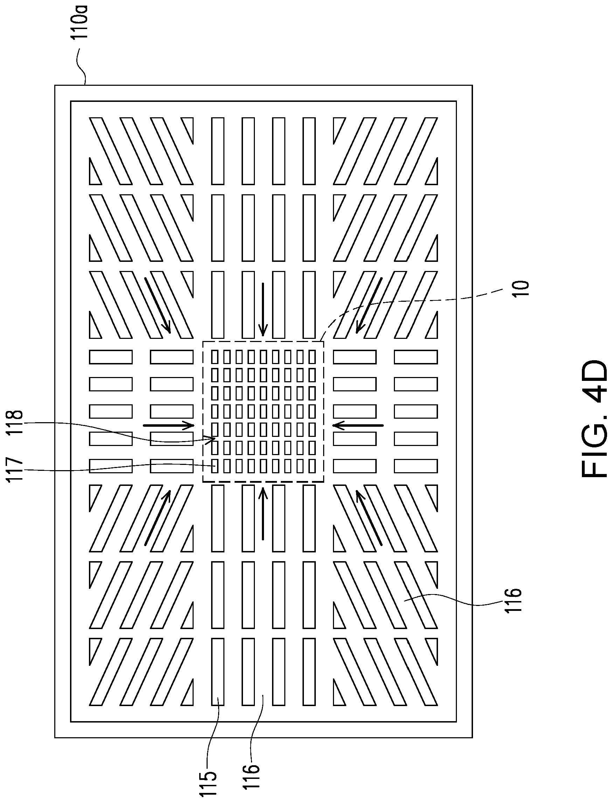

FIG. 4D is a schematic view of an inner surface of a first shell according to other embodiments of the disclosure. With reference to FIG. 4D, in this embodiment, a first shell 110a has a plurality of first trenches 116 in different directions, and the first trenches 116 are radially shaped to reduce the flow resistance and allow the condensed liquid to flow back quickly. The arrangement of the first trenches 116 is not limited to a radial shape, and any arrangement pattern sufficient to guide the working fluid (liquid) may be used.

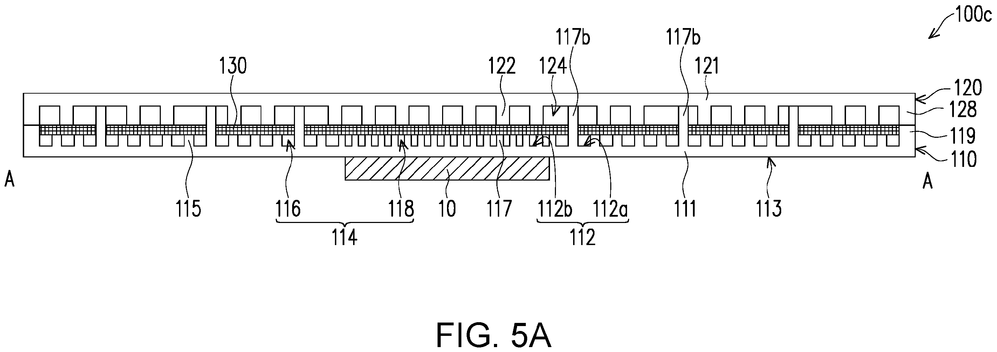

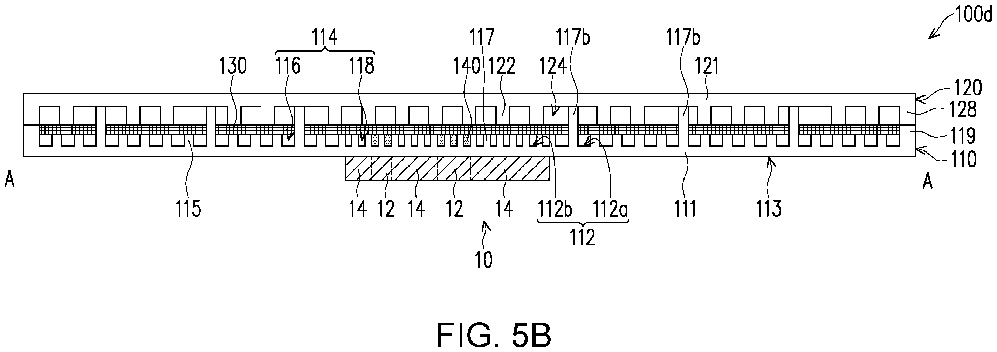

FIG. 5A and FIG. 5B are cross-sectional schematic views of vapor chamber devices according to other embodiments of the disclosure. With reference to FIG. 5A and FIG. 5B, main differences between a vapor chamber device 100c of FIG. 5A and the vapor chamber device 100 of FIG. 1B and between a vapor chamber device 100d of FIG. 5B and the vapor chamber device 100a of FIG. 2A are that in FIG. 5A and FIG. 5B, in order to increase the structural strength of the vapor chamber devices 100c and 100d, each of the vapor chamber devices 100c and 100d is specially provided with top bonding posts 117b in regions within the first side wall 119 of the first shell 110. In regions on the second plate 121 corresponding to the protruding top bonding posts 117b of the first plate 111, a portion of the supporting posts 122 must be removed to reserve space for the top bonding posts 117b and to allow these top bonding posts 117b to be bonded to the second plate 121. When the top bonding posts 117b and the second plate 121 are cold-worked, the top bonding posts 117b and the second plate 121 may be bonded by welding. During hot working, the first shell 110 and the second shell 120 may be bonded by diffusion bonding or the like to enhance the connection therebetween and achieve sufficient anti-expansion properties.

In this embodiment, since the top bonding posts 117b and the supporting posts 122 are staggered with each other, precise alignment between the first shell 110 and the second shell 120 is not required. Even if there is any offset between the first shell 110 and the second shell 120 during the manufacturing process, it may not have any impact on the bonding between the top bonding posts 117b and the second plate 121, and the process is convenient. Further, direct bonding to the second plate 121 may be implemented through the top bonding posts 117b, so that the bonding strength between the first shell 110 and the second shell 120 may be easily maintained.

In view of the foregoing, in the vapor chamber device provided by the disclosure, the inner surface of the first shell includes the first region and the second region. The first capillary structure located on the inner surface includes the first ridges and the first trenches located in the first region and the second ridges and the second trenches located in the second region. The width of each of the second trenches is less than the width of each of the first trenches. Through such a design, the capillary force of these second trenches is enhanced, and the heat dissipation efficiency is thus effectively improved.

## Claims

1. A vapor chamber device (100, 100a to 100d), comprising:
a first shell (110, 110a) comprising a first plate (111), a first capillary structure (114) located on an inner surface (112) of the first plate (111), and a first side wall (119) protruding from the inner surface (112) and surrounding the first capillary structure (114), wherein the first capillary structure (114) acts as a liquid channel, the inner surface (112) comprises a first region (112a) and a second region (112b), the first capillary structure (114) comprises a plurality of first trenches (116) formed between a plurality of first ridges (115) and a plurality of second trenches (118) formed between a plurality of second ridges (117), the first ridges (115) and the first trenches (116) are located in the first region (112a), the second ridges (117) and the second trenches (118) are located in the second region (112b), and a width (W2) of each of the second trenches (118) is less than a width (W1) of each of the first trenches (116);
a second shell (120, 120a, 120b) stacked on the first shell (110, 110a) and comprising a second plate (121), a plurality of supporting posts (122, 123, 125) protruding from the second plate (121), and a second side wall (128) protruding from the second plate (121) and surrounding the supporting posts (122, 123, 125), wherein a plurality of steam channels (124) are formed between the supporting posts (122, 123, 125), the supporting posts (122, 123, 125) face the first capillary structure (114), and the first side wall (119) is bonded to the second side wall (128); and
a second capillary structure (130) disposed between the first capillary structure (114) and the supporting posts (122, 123, 125) of the second shell (120, 120a, 120b).

2. The vapor chamber device (100, 100a to 100d) according to claim 1, further comprising:
a heat source (10) disposed adjacent to an outer surface (113) of the first plate (111) and thermally coupled to the first plate (111), wherein the second trenches (118) are disposed corresponding to the heat source (10), and the first trenches (116) are disposed corresponding to locations outside the heat source (10).

3. The vapor chamber device (100, 100a to 100d) according to claim 1, wherein a ratio of the width (W2) of each of the second trenches (118) to the width (W1) of each of the first trenches (116) is between 0.3 and 0.9.

4. The vapor chamber device (100, 100a to 100d) according to claim 1, further comprising:
a third capillary structure (140) disposed in at least one strong heat dissipation portion (112c) in the second region (112b), wherein the third capillary structure (140) is not provided in a remaining portion (112d) of the second region (112b) outside the at least one strong heat dissipation portion (112c).

5. The vapor chamber device (100, 100a to 100d) according to claim 4, wherein the second region (112b) is filled with the second trenches (118).

6. The vapor chamber device (100, 100a to 100d) according to claim 4, wherein the second trenches (118) are only located in a portion of the second region (112b), the at least one strong heat dissipation portion (112c) is located at a portion of the second region (112b) where the second trenches (118) are not provided, and the at least one strong heat dissipation portion (112c) is provided with a plurality of protruding posts (117a) abutting against the second capillary structure (130).

7. The vapor chamber device (100, 100a to 100d) according to claim 4, wherein a ratio of an area of the at least one strong heat dissipation portion (112c) where the third capillary structure (140) is disposed to an area occupied by the second region (112b) is less than 0.5.

8. The vapor chamber device (100, 100a to 100d) according to claim 4, wherein a ratio of an area of the at least one strong heat dissipation portion (112c) where the third capillary structure (140) is disposed to an area occupied by the second region (112b) is less than 0.25.

9. The vapor chamber device (100, 100a to 100d) according to claim 4, further comprising:
a heat source (10) disposed adjacent to an outer surface (113) of the first plate (111) and thermally coupled to the first plate (111), the heat source (10) comprises at least one hot spot (12) and a relatively non-hot spot region (14) outside the at least one hot spot (12), and a position of the at least one strong heat dissipation portion (112c) where the third capillary structure (140) is disposed corresponds to a position of the at least one hot spot (12).

10. The vapor chamber device (100, 100a to 100d) according to claim 9, wherein the position of the at least one strong heat dissipation portion (112c) corresponds to a center of the heat source (10), and the remaining portion (112d) of the second trenches (118) surrounds the strong heat dissipation portion (112c).

11. The vapor chamber device (100, 100a to 100d) according to claim 1, wherein the first shell (110, 110a) further comprises a plurality of top bonding posts (117b), the top bonding posts (117b) are disposed on the inner surface (112) of the first plate (111) and directly connected to the second plate (121).
